# FASCICULE DE BREVET EUROPEEN

(11) **EP 2 175 705 B1**
(45) Date de publication et mention de la délivrance du brevet: **04.01.2012**
(21) Numéro de dépôt: 09172640.6
(22) Date de dépôt: 09.10.2009
(51) Int. Cl.: H05K 3/34, H05K 13/04, B23K 1/005, B23K 3/08

(54) **Procédé et dispositif d'assemblage d'une pastille sur un substrat par apport d'une masse formant brasure**
Verfahren und Gerät zum Zusammenbau einer Pastille auf einem Substrat durch Zufuhr von Lötmaterial
Process and device for assembly of a pastille on a substrate by supply of brazing material

(30) Priorité: 10.10.2008 FR 0856876
(43) Date de publication de la demande: 14.04.2010
(73) Titulaire: Valeo Etudes Electroniques, 94042 Créteil Cédex (FR)
(72) Inventeur: Vivet, Laurent, 94000 Creteil (FR); Morelle, Jean-Michel, 94000 Creteil (FR); Dimelli, Sandra, 94000 Creteil (FR); Deneu-Fontaine, Laurent, 94000 Creteil (FR); Lenoir, Romaric, 94000 Creteil (FR)
(74) Mandataire: Cardon, Nicolas

(56) Documents cités:
- FR-A- 2 003 802
- FR-A- 2 905 883

## Description

La présente invention concerne le domaine technique du brasage d'un organe sur un substrat par apport d'une masse formant brasure.

Elle s'applique plus particulièrement mais non spécifiquement au contrôle du chauffage de la masse formant brasure.

Il est connu dans l'état de la technique un procédé de soudage d'un élément, telle qu'une pastille, sur un substrat par apport d'une masse formant brasure, dans lequel:
- on forme une pile verticale d'axe coïncidant sensiblement avec la direction de la pesanteur comprenant, du haut vers le bas, la pastille, la masse dans un état solide et le substrat,
- on chauffe la masse de manière à la faire passer dans un état liquide lui permettant de s'étaler sur le substrat.

La qualité de la brasure dépend notamment des propriétés de mouillabilité de la surface du substrat assurant un bon mouillage, c'est-à-dire un étalement suffisant, de la masse sur le substrat. De façon plus précise, la mouillabilité de la surface est définie par un angle de contact, également désigné par angle de mouillage, formé entre la tangente à la surface de la masse et la tangente à la surface du substrat en un point de contact de la masse et du substrat.

Afin d'assurer un bon mouillage de la masse sur le substrat, il est souhaitable d'augmenter la durée de la période au cours de laquelle la masse est dans son état liquide, par exemple en augmentant la durée de chauffage de la masse afin d'assurer un étalement suffisant de cette dernière sur le substrat.

Or, alors que la durée de chauffage peut être déterminée relativement aisément, il est difficile de déterminer avec précision la durée de la période au cours de laquelle la masse est effectivement dans son état liquide.

Le chauffage de la masse est par exemple obtenu en irrandiant la masse par une source laser continue contrôlée de manière à produire des impulsions longues, par exemple de durée supérieure à environ deux secondes.

Dans ce cas, la durée de propagation de la chaleur à travers le substrat et la masse n'est plus négligeable par rapport à la durée d'une impulsion laser qui correspond à la durée de chauffage.

Par conséquent, la durée de la période au cours de laquelle la masse est effectivement dans son état liquide ne correspond pas nécessairement à la durée de chauffage.

L'invention a notamment pour but de proposer un procédé d'assemblage d'un élément sur un substrat par apport d'une masse formant brasure permettant de contrôler avec précision la durée de la période au cours de laquelle la masse est dans son état liquide afin d'optimiser son mouillage sur le substrat.

A cet effet, l'invention a pour objet un procédé d'assemblage d'un élément sur un substrat par apport d'une masse formant brasure, dans lequel:
- on forme une pile verticale d'axe coïncidant sensiblement avec la direction de la pesanteur comprenant, du haut vers le bas, l'élément, la masse dans un état solide et le substrat,
- on chauffe la masse de manière à la faire passer dans un état liquide lui permettant de s'étaler sur le substrat,
caractérisé en ce que, après formation de la pile, l'élément est laissé libre de se déplacer verticalement dans les deux sens, soit à la fois vers le haut et vers le bas, en ce que, au cours du chauffage, on mesure la variation de la position verticale de l'élément.

La masse est une masse autoportée, c'est à dire une masse indépendante de l'élément et du substrat, qui peut être rapportée sur la pile séparément de l'élément et du substrat.

Grâce à ce procédé, il est possible de connaître avec précision la durée au cours de laquelle la masse est dans son état liquide. En effet, tant que la masse est à l'état solide, elle exerce sur l'élément une force de réaction compensant la force de pesanteur exercée par l'organe sur la masse. L'élément est alors immobile.

Puis, au cours du chauffage, la masse se liquéfie et l'intensité de la force de réaction exercée par la masse sur l'élément devient inférieure à l'intensité de la force de pesanteur exercée par l'élément sur la masse, ce qui provoque le déplacement de l'élément sous l'action de sa pesanteur vers le substrat.

Il est alors possible de déterminer l'évolution de l'état de la masse en fonction de la mesure de la variation du déplacement de l'organe.

Un procédé d'assemblage selon l'invention peut en outre comporter l'une ou plusieurs des caractéristiques selon lesquelles:
- on arrête le chauffage de la masse en fonction d'un paramètre dépendant de la mesure de la variation de la position verticale de l'élément ;
- au cours du chauffage, on détecte une stabilisation de la position verticale de l'élément consécutive à un abaissement de l'élément et on arrête le chauffage de la masse après une durée prédéterminée comptée à partir de la détection de la stabilisation ;
- pour chauffer la masse, on dirige un faisceau laser sur une première face du substrat opposée à une deuxième face de ce substrat portant la masse, au droit de cette masse.

L'invention a encore pour objet un dispositif d'assemblage d'un élément sur un substrat par apport d'une masse formant brasure, comprenant des moyens de déplacement de l'élément comportant un support portant un organe de préhension de l'élément, caractérisé en ce que l'organe de préhension est monté libre en translation sur le support parallèlement à un axe de translation dit vertical, et en ce qu'il est configuré de sorte que l'élément est libre de se déplacer verticalement dans les deux sens, soit à la fois vers le haut et vers le bas, **et en ce qu**'il comprend des moyens de mesure de la variation en translation verticale de la position de l'élément.
Un dispositif d'assemblage selon l'invention peut en outre comporter l'une ou plusieurs des caractéristiques selon lesquelles:
- le dispositif comprend des moyens de chauffage et des moyens de pilotage des moyens de chauffage en fonction de la variation de la position de l'élément;
- le dispositif comprend des moyens de limitation de la course en translation verticale de l'élément ;
- le dispositif comprend des moyens formant contrepoids s'opposant au moins partiellement au poids de l'organe de préhension ;
- les moyens de mesure de la variation de la position de l'élément sont des moyens de mesure de la variation en translation verticale de la position de l'organe de préhension ;
- les moyens de mesure comprennent des moyens d'émission d'un faisceau lumineux incident destiné à émettre un faisceau sur une surface de l'organe de préhension sensiblement perpendiculaire à l'axe vertical et des moyens de réception d'une partie du faisceau réfléchi par cette surface,
- les moyens de mesure comprennent un capteur de déplacement à triangulation laser.

L'invention sera mieux comprise à la lecture de la description qui va suivre, donnée uniquement à titre d'exemple et faite en se référant aux dessins dans lesquels :
- la figure 1 est une vue de côté d'une installation d'assemblage d'un élément sur un substrat comprenant un dispositif d'assemblage pour la mise en oeuvre d'un procédé d'assemblage selon l'invention
- la figure 2 est une vue de face de l'installation illustrée sur la figure 1;
- les figures 3 à 5 sont des vues de face de l'installation d'assemblage de la figure 1, illustrant différentes étapes du procédé d'assemblage selon l'invention ;
- la figure 6 est un graphique représentant une courbe d'évolution de la variation de la position de l'élément en fonction du temps.

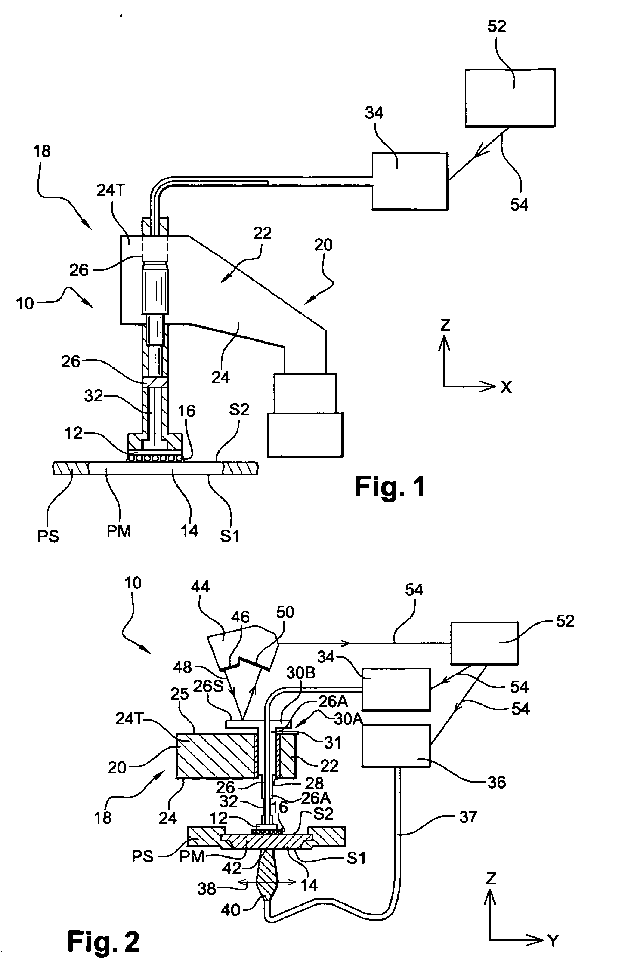

On a représenté sur les figures 1 et 2 une installation désignée par la référence générale 10. L'installation 10 permet d'assembler un élément 12 sur un substrat 14 par apport d'une masse 16 formant brasure. Dans l'exemple décrit, l'élément 12 est une pastille semi-conductrice classique. La masse 16 est une masse autoportée indépendante de l'élément 12 et du substrat 14 et se présente par exemple sous forme de pâte à braser ou d'un fin ruban découpé en disque ou en rectangle.

Le substrat 14 comporte dans l'exemple décrit une partie métallique PM, notamment en cuivre, bordée partiellement par une partie PS en matériau synthétique formant une partie d'un boîtier de protection de la pastille semi-conductrice 12 portée par le substrat 14. Le substrat 14 comporte des première S1 et seconde S2 faces opposées. La masse 16 est destinée à être portée par la seconde face S2 de la partie métallique PM du substrat. De préférence, la seconde face S2 est recouverte d'une fine couche de nickel.

Afin d'assembler la pastille 12 sur le substrat 14, l'installation d'assemblage 10 comprend un dispositif d'assemblage 18. Ce dispositif d'assemblage 18 comprend des moyens 20 de déplacement de la pastille 12 ou de la masse 16 de manière à la déposer sur la seconde face S2 du substrat 14.

Ces moyens de déplacement 20 comprennent des moyens articulés 22 permettant le déplacement de la pastille 12 ou de la masse 16 dans un plan horizontal sensiblement parallèle à des axes X et.Y et dans une direction verticale sensiblement parallèle à un axe Z.

En particulier, les moyens articulés 22 comprennent dans cet exemple, un bras 24 muni d'une tête 24T. Cette tête 24T comprend un support 25 portant un organe 26 de préhension de la pastille 12 ou de la masse 16.

Plus particulièrement, l'organe 26 est monté libre en translation sur le support 25 parallèlement à un axe de translation dit vertical, sensiblement parallèle à l'axe Y.

Par exemple, l'organe de préhension 26 est relié à la tête 24T au moyen d'une liaison glissière. A cet effet, la tête 24T comprend un trou 28 traversant de guidage de l'organe 26.

Ainsi, l'organe de préhension 26 a par exemple une forme générale en T comprenant une première partie 26A formant la jambe du T et une deuxième partie 26B formant la barre du T. De préférence, la première partie 26A a une forme générale complémentaire à une paroi interne 281 du trou 28 permettant ainsi à l'organe de préhension 26 de coulisser à l'intérieur du trou 28. Par exemple, l'effort de frottement généré lors de la translation de l'organe 26 à l'intérieur du trou 28 a une valeur inférieure à dix grammes/ force générer

De préférence, le dispositif 18 comporte des moyens 30 de limitation de la course en translation verticale de l'organe 26 et ainsi plus précisément de la pastille 12 destinée à être portée par l'organe 26. Par exemple, les moyens de limitation 30 comprennent un premier élément 30A formant butée ménagé sur le support 25 et un deuxième élément formant butée 30B formé par une des extrémités de la deuxième partie 26B de l'organe 26, les éléments formant butée 30A et 30B étant destinés à venir en contact l'un avec l'autre lors du déplacement selon la direction de l'axe vertical Y de l'organe de préhension 26 afin de limiter la course de ce dernier.

Par exemple, le premier élément 30A est formé par une cale 31 destinée à s'étendre sur une surface 25S du support 25 de la tête 24T.

Par ailleurs, l'organe de préhension 26 est par exemple à aspiration. Ainsi, l'organe de préhension 26 comprend un conduit d'aspiration 32 relié à l'une de ses extrémités à des moyens d'aspiration 34 comportant par exemple une pompe à vide. Ce conduit d'aspiration 32 s'étend à l'intérieur d'un trou traversant l'organe de préhension 26 dans sa direction longitudinale, l'autre des extrémités du conduit 32 débouchant à une extrémité de l'organe de préhension 26 destinée à venir en contact avec la pastille 12 en cours d'assemblage sur le substrat 14.

De préférence, l'organe de préhension 26 peut être solidarisé avec la tête 24T à l'aide de moyens de liaisons libérables susceptibles d'adopter un état actif dans lequel l'organe 26 est relié à la tête 24T solidairement avec celle-ci et un état de repos dans lequel l'organe 26 est libre par rapport à la tête 24T.

Dans l'exemple décrit, le dispositif 18 comprend encore des moyens formant contrepoids (non représentés) à l'égard de l'organe de préhension 26. Ainsi, ces moyens formant contrepoids s'opposent au moins partiellement, de préférence complètement, au poids de l'organe de préhension 26. Toutefois, le poids résiduel correspondant à la somme du poids de l'organe de préhension 26 compensé au moins partiellement par les moyens formant contrepoids et du poids de la pastille 12 portée par l'organe de préhension 26 doit être légèrement supérieur à l'effort de frottement généré lors de la translation de l'organe 26 à l'intérieur du trou 28.

Afin de chauffer la masse 16 pour provoquer la fusion de la brasure, l'installation 10 comprend des moyens 36 de chauffage comprenant par exemple une source laser continue et contrôlée pour produire des impulsions de durée prédéterminée, par exemple égale à deux secondes, une fibre optique 37 de guidage d'un faisceau laser 40 émis par la source et des moyens 38 de focalisation du faisceau laser 40 en un point 42 au droit de la masse 16 formant brasure.

Le dispositif 18 comprend également des moyens 44 de mesure de la variation en translation verticale de la position de la pastille 12. Ces moyens de mesure 44 sont des moyens de mesure de la variation en translation verticale de la position de l'organe de préhension 26.

De préférence, les moyens de mesure 44 comprennent des moyens 46 d'émission d'un faisceau lumineux incident destiné à émettre un faisceau 48 sur une surface 26S de l'organe de préhension 26 sensiblement perpendiculaire à l'axe Y et des moyens 50 de réception d'une partie du faisceau réfléchi 48 par cette surface 26S.

De préférence, les moyens de mesure 44 comprennent un capteur de déplacement à triangulation laser. Ainsi, les moyens d'émission 46 comprennent une source laser infrarouge ainsi que des moyens de focalisation du faisceau incident 48 émis par la source laser sur la surface 26S. Les moyens de réception 50 comprennent de préférence une cellule CCD. Pour mesurer le déplacement de l'organe 26, on mesure la variation de la position du point d'impact du faisceau réfléchi 48 sur la cellule CCD, cette variation étant liée à la variation de la position de la surface 26S de l'organe 26.

De préférence, la surface 26S s'étend sur la face supérieure de la deuxième partie 26B de l'organe 26.

Ces moyens 44 peuvent mesurer avec une précision d'un micromètre la variation de la position de l'organe 26 selon un axe perpendiculaire à la surface 26S de l'organe et fonctionnent à haute fréquence d'acquisition (environ cinq kHz).

De même, les moyens de déplacement 22 permettent de positionner l'organe 26 avec une précision d'environ un micromètre.

L'installation 10 comprend par ailleurs des moyens 52 de pilotage des moyens de chauffage 36 en fonction de la variation de la position de l'élément 12 ou 16. A cet effet, le dispositif 18 comprend des moyens 54 de communication classiques (filaire, infra-rouge, etc.) entre les moyens de mesure 44, les moyens de chauffage 36 et les moyens de déplacement 22.

On va maintenant décrire les principaux aspects d'un procédé d'assemblage selon l'invention mise en oeuvre dans l'installation d'assemblage décrite ci-dessus.

Tout d'abord, on forme une pile 56 verticale d'axe Y coïncidant sensiblement avec la direction de la pesanteur comprenant, du haut vers le bas, la pastille 12, la masse 16 dans un état solide et le substrat 14.

Afin de former cette pile 56, le bras articulé 22 déplace l'organe de préhension 26 solidaire de la tête 24T et les moyens de pilotage 52 activent les moyens d'aspiration 34 afin que la masse 16 soit saisie par aspiration par l'organe 26 puis déplacée vers le substrat 14 par le bras articulé 22.

Le déplacement de l'organe de préhension 26 est relativement précis car directement lié à celui des moyens articulés 22.

Dès la détection de la position de contact de la masse 16 avec la surface S2 du substrat 14, on désactive les moyens d'aspiration 34 de sorte que l'organe de préhension 26 libère la masse 16 sur le substrat 14.

Puis, au cours d'une seconde étape, on met en place la pastille 12 sur la masse 16 en procédant de la même façon.

Dès la détection de la position de contact de la pastille 12 avec la masse 16, on désactive les moyens de liaison libérables de la tête 24T avec l'organe de préhension 26 de manière à ce que l'organe 26 puisse se déplacer en translation librement dans le trou 28 de la tête 24T.

Dans cette position, la deuxième partie 26B de l'organe de préhension 26 est située au-dessus de la cale 31 et la distance selon l'axe vertical Y entre la cale 31 et la deuxième partie 26B définit une course maximale de l'organe 26 en translation. La valeur de cette course est choisie de manière à permettre une mesure suffisamment précise de la variation de la hauteur de l'organe 26 tout en préservant la qualité de la brasure. En effet, une valeur de course trop importante risque de provoquer l'expulsion de la masse sur les côtés de la pastille et donc de former un joint de brasure d'épaisseur réduite sous la pastille 12.

Par exemple, cette distance est égale à 2.5 micromètres et correspond sensiblement à une variation de la hauteur de la masse 16 lors du changement de son état solide à son état liquide par rapport au substrat 14. Toutefois, on notera qu'une course de l'organe 26 égale à dix micromètres permet d'obtenir une mesure relativement précise de la variation de la hauteur sans risquer de provoquer l'expulsion de la masse sur les côtés de la pastille 12, lors du déplacement de la pastille 12 contre la masse.

Les moyens de pilotage 52 pilotent le démarrage du chauffage de la masse 16. A cet effet, on chauffe la masse 16 à une température prédéterminée pendant une durée prédéterminée correspondant par exemple à une durée de l'impulsion laser. A cet effet, on dirige le faisceau laser 40 sur la première face S1 du substrat. Plus précisément, on dirige le faisceau laser 40 au droit de la masse 16 pendant une période d'irradiation du substrat 14 par le faisceau 40. Cette période d'irradiation correspond sensiblement à la durée prédéterminée de chauffage de la masse 16.

Au cours d'une période T1, la température de la masse 16 augmente sans que son état ne change. Dans cette période, la masse 16 exerce une force de réaction sur la pastille 12 permettant de compenser sensiblement la force de pesanteur exercée par la pastille 12 sur la masse 16.

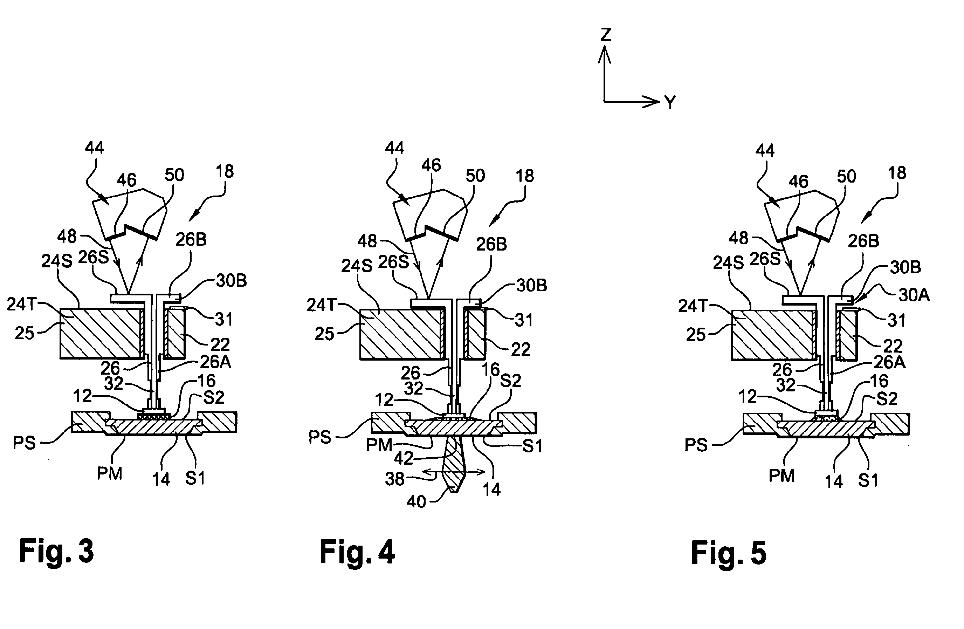

Puis, au cours d'une période T2, la masse 16 passe d'un état solide à un état liquide lui permettant de s'étaler sur le substrat 14 comme cela est visible sur la figure 4. L'intensité de la force de réaction exercée sur la pastille 12 par la masse 16 à l'état liquide diminue.

Ainsi, au cours de cette période T2, du fait que l'organe de préhension 26 est monté libre en translation dans le trou 28 de la tête 24T, l'organe de préhension 26 descend en translation selon la direction de l'axe vertical Y correspondant également à la direction de la pesanteur, entraîné par le poids de la pastille 12 et une partie résiduelle de son poids (non compensée par les moyens formant contrepoids), en coulissant dans le trou 28 de la tête 24T.

La compensation au moins partielle du poids de l'organe 26 par les moyens formant contrepoids permet de limiter la pression exercée par la pastille 12 sur la masse liquide 16 au cours de l'étape de chauffage et d'éviter ainsi les risques de fluage de la masse sur les côtés de la pastille 12 et la compression de la pastille 12 directement sur le substrat 14.

Les moyens de mesure 44 détectent la variation de la position de l'organe de préhension 26, ce qui permet d'en déduire la variation de la position de la pastille 12.

La descente selon l'axe Y de la pastille 12 s'arrête lorsque la masse 16 est entièrement dans son état liquide ce qui se produit lorsque l'extrémité de la deuxième partie 26B de l'organe 26 vient en butée de l'organe 26 contre la cale 31 s'étendant sur la tête 24T. La pastille 12 est alors stabilisée.

Les moyens de mesure 44 détectent alors la stabilisation de la position verticale de la pastille 12 consécutive à l'abaissement de la pastille 12 et envoient un signal aux moyens de pilotage 52 qui déclenchent à partir de l'instant de cette détection de stabilisation, un chronomètre pour compter la durée prédéterminée. Cette durée prédéterminée est égale à environ une seconde.

Ainsi, les moyens de pilotage 52 maintiennent l'activation des moyens de chauffage 36 de la masse 16 pendant la durée prédéterminée comptée à partir de la stabilisation de la position de la pastille 12.

A la fin de cette durée prédéterminée, les moyens de pilotage 52 arrêtent le chauffage. La position de la pastille 12 ne varie pas tant que la masse 16 reste encore liquide après l'arrêt du chauffage. La période au cours de laquelle la masse 16 est à l'état liquide correspond à la période T3. Cette période T3 correspond à la période au cours que laquelle la position de la pastille 12 est stabilisée.

Puis, la masse 16 commence à se solidifier comme cela est représenté sur la figure 4. Cette phase de solidification correspond à une période T4.

En se solidifiant, la force de réaction exercée par la masse 16 sur la pastille 12 augmente ce qui va provoquer une légère remontée de la pastille 12 selon la direction verticale, comme cela est visible sur la figure 5.

Lorsque la masse 16 est entièrement solidifiée, la position de la pastille se stabilise ce qui correspond à la période T5.

Ainsi, lorsque les moyens de mesure 44 détectent la stabilisation de la position haute en Y de la pastille 12, ils envoient un signal aux moyens de pilotage 52 de manière à ce que ces derniers pilotent l'arrêt des moyens d'aspiration 34. Ces derniers libèrent alors la pastille 12.

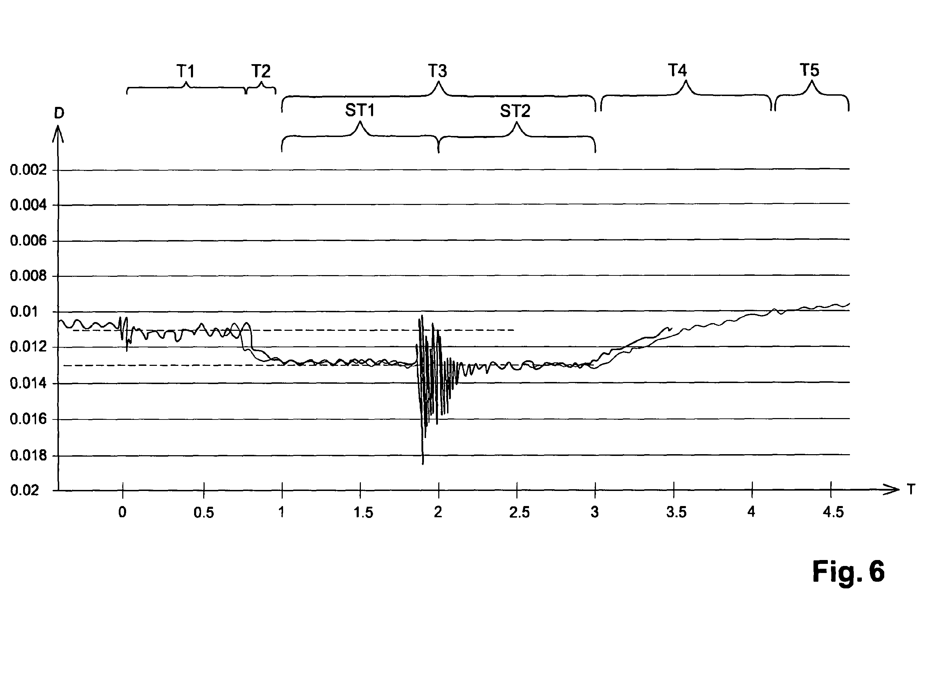

A l'issue de ces différentes étapes, les moyens de mesure 44 fournissent le graphe de la figure 6 représentant une courbe C de l'évolution temporelle de la variation de la position de la pastille 12. On a représenté sur ce graphe en abscisse le temps T en seconde (s) et en ordonnée la distance D en millimètre (mm).

Ainsi, la courbe C comprend :
- une première portion T1 à pente nulle correspondant à la période T1 précédemment décrite,
- une deuxième portion T2 à pente négative correspondant à la période T2 au cours de laquelle la pastille 12 descend en direction du substrat 14 du fait de la liquéfaction de la masse 16,
- une troisième portion T3 à pente nulle correspondant à la période T3 au cours de laquelle la pastille 12 se stabilise. Cette période T3 se divise en une première partie ST1 au cours de laquelle le chauffage de la masse 16 est maintenu et une deuxième partie ST2 au cours de laquelle le chauffage est arrêté, la masse 16 restant encore à l'état liquide,
- une quatrième portion T4 à pente positive correspondant à la période T4 au cours de laquelle la masse 16 commence à se solidifier ce qui provoque la remontée de la pastille 12,
- une cinquième portion T5 à pente nulle correspondant à la période T5 de stabilisation de la pastille 12 consécutive à la remontée de cette dernière selon l'axe Y.

Ainsi, on peut obtenir à partir du graphe de la figure 6 la durée de mouillage, cette dernière correspondant sensiblement à la durée de stabilisation de la pastille 12 consécutive à un abaissement, c'est-à-dire la durée de la période T3.

On peut grâce à ce procédé déterminer avec une grande précision la durée de mouillage de la masse 16 sur le substrat en observant les variations de la position de la pastille 12.

En particulier, la durée de la période au cours de laquelle la masse 16 est à l'état liquide a une valeur minimale contrôlée et programmable.

Par ailleurs, pour chaque opération d'assemblage de la pastille sur le substrat, on enregistre le graphe comprenant la courbe décrivant les principales phases déterminées ci-dessus. Grâce à cette courbe, il est possible de déterminer un écart anormal par rapport à des valeurs désirées de durée de chacune des périodes distinctes identifiées.

En outre, il est possible de contrôler la durée de la phase de solidification de la masse 16 et de déterminer les cas où cette dernière est trop longue. En effet une durée de solidification trop longue peut nuire à la qualité du joint brasé formé par la masse solidifiée.

Par ailleurs, il est possible de déterminer avec une grande précision l'instant où la solidification de la masse est achevée. Ceci permet de gagner du temps dans l'opération d'assemblage car l'organe de préhension peut libérer la pastille dès cet instant sans courir le risque d'un déplacement intempestif de la pastille sur la masse, la masse à l'état solide assurant une excellente adhérence de la pastille sur cette dernière.

## Revendications

1. Procédé d'assemblage d'un élément (12), tel qu'une pastille, sur un substrat (14) par apport d'une masse (16) formant brasure, dans lequel
- on forme une pile verticale (56) d'axe coïncidant sensiblement avec la direction de la pesanteur comprenant, du haut vers le bas, l'élément (12), la masse (16) dans un état solide et le substrat (14),
- on chauffe la masse (16) de manière à la faire passer dans un état liquide lui permettant de s'étaler sur le substrat (12),
et après formation de la pile (56), l'élément (12) est laissé libre de
se déplacer verticalement dans les deux sens, soit à la fois vers le haut et vers le bas, et **caractérisé en ce que**, au cours du chauffage, on mesure la variation de la position verticale de
l'élément (12).

2. Procédé selon la revendication 1, dans lequel on arrête le chauffage de la masse (16) en fonction d'un paramètre dépendant de la mesure de la variation de la position verticale de l'élément (12).

3. Procédé selon la revendication 1 ou 2, dans lequel au cours du chauffage, on détecte une stabilisation de la position verticale de l'élément (12) consécutive à un abaissement de l'élément (12) et on arrête le chauffage de la masse (16) après une durée prédéterminée comptée à partir de la détection de la stabilisation.

4. Procédé selon l'une quelconque des revendications 1 à 3, dans lequel pour chauffer la masse (16), on dirige un faisceau laser sur une première face du substrat (14) opposée à une deuxième face de ce substrat (14) portant la masse (16), au droit de cette masse (16).

5. Dispositif (18) d'assemblage d'un élément (12) sur un substrat par apport d'une masse formant brasure (16), comprenant des moyens (22) de déplacement de l'élément (12) comportant un support (25) portant un organe (26) de préhension de l'élément, **caractérisé en ce que** l'organe de préhension (26) est monté libre en translation sur le support (25) parallèlement à un axe de translation dit vertical, et **en ce qu'**il est configuré de sorte que l'élément est libre de se déplacer verticalement dans les deux sens, soit à la fois vers le haut et vers le bas, et **en ce qu'**il comprend des moyens (44) de mesure de la variation en translation verticale de la position de l'élément (12).

6. Dispositif (18) selon la revendication précédente, comprenant des moyens (36) de chauffage et des moyens (52) de pilotage des moyens de chauffage (36) en fonction de la variation de la position de l'élément.

7. Dispositif (18) selon la revendication 5 ou 6, comprenant des moyens (30, 30A, 30B) de limitation de la course en translation verticale de l'élément (12).

8. Dispositif (18) selon l'une quelconque des revendications 5 à 7, comprenant des moyens formant contrepoids s'opposant au moins partiellement au poids de l'organe de préhension (26).

9. Dispositif (18) selon l'une quelconque des revendications 5 à 8, dans lequel les moyens de mesure (44) de la variation de la position de l'élément (12) sont des moyens de mesure de la variation en translation verticale de la position de l'organe de préhension (26).

10. Dispositif (18) selon la revendication précédente, dans lequel les moyens de mesure (44) comprennent des moyens (46) d'émission d'un faisceau lumineux incident destiné à émettre un faisceau (48) sur une surface (26S) de l'organe de préhension (26) sensiblement perpendiculaire à l'axe vertical et des moyens (50) de réception d'une partie du faisceau réfléchi (48) par cette surface (26S).

11. Dispositif (18) selon l'une quelconque des revendications 5 à 10, dans lequel les moyens de mesure (44) comprennent un capteur de déplacement à triangulation laser.

## Claims

1. Method for joining an element (12), such as a chip, to a substrate (14) by providing a body of solder (16), in which
- a vertical stack (56), having an axis that substantially coincides with the direction of gravity, comprising, from top to bottom, the element (12), the body of solder (16) in solid state and the substrate (14) is formed; and
- the body of solder (16) is heated so as to make it pass into a liquid state, enabling it to spread over the substrate (12),
**characterized in that**, after the stack (56) has been formed, the element (12) is free to move vertically in both directions, i.e. both upwards and downwards, and **in that** during the heating the variation in the vertical position of the element (12) is measured.

2. Method according to Claim 1, in which heating of the body of solder (16) is stopped as a function of a parameter dependent on the measurement of the variation in the vertical position of the element (12).

3. Method according to either one of Claims 1 and 2, in which, during the heating, a stabilization in the vertical position of the element (12) is detected after lowering of the element (12) and heating of the body of solder (16) is stopped after a preset period of time starting from when the stabilization is detected.

4. Method according to any one of Claims 1 to 3, in which, to heat the body of solder (16), a laser beam is directed onto a first face of the substrate (14) opposite a second face of this substrate (14) bearing the body of solder (16), in line with this body of solder (16).

5. Device (18) for joining an element (12) to a substrate by providing a body of solder (16), comprising means (22) for moving the element (12) comprising a support (25) bearing a member (26) for gripping the element, **characterized in that** the gripping member (26) is mounted so as to be free to undergo translation on the support (25), parallel to what is called a vertical translation axis, and **in that** it is configured so that the element is free to move vertically in both directions, i.e. both upwards and downwards, and **in that** it comprises means (44) for measuring the variation in the vertical translational position of the element (12).

6. Device (18) according to the preceding claim, comprising heating means (36) and means (52) for controlling the heating means (36) as a function of the variation in the position of the element.

7. Device (18) according to either one of Claims 5 and 6, comprising means (30, 30A, 30B) for limiting the vertical translational movement of the element (12).

8. Device according to any one of Claims 5 to 7, comprising means forming a counterweight offsetting at least partially the weight of the gripping member (26).

9. Device (18) according to any one of Claims 5 to 8, in which the means (44) for measuring the variation in the position of the element (12) are means for measuring the variation in the vertical translational position of the gripping member (26).

10. Device (18) according to the preceding claim, in which the measurement means (44) comprise means (46) for emitting an incident light beam, intended to emit a beam (48) towards a surface (26S) of the gripping member (26) substantially perpendicular to the vertical axis and means (50) for receiving a portion of the beam (48) reflected from this surface (26S).

11. Device (18) according to any one of Claims 5 to 10, in which the measurement means (44) comprise a laser-triangulation movement sensor.

## Patentansprüche

1. Verfahren zum Montieren eines Elements (12) wie etwa einer Pastille auf einem Substrat (14) durch Aufbringen einer ein Lötmittel bildenden Masse (16), wobei
- ein vertikaler Stapel (56) gebildet wird, dessen Achse im Wesentlichen mit der Richtung der Schwerkraft zusammenfällt und der von oben nach unten das Element (12), die Masse (16) in einem festen Zustand und das Substrat (14) umfasst,
- die Masse (16) erhitzt wird, derart, dass sie in einen flüssigen Zustand übergeht, was ihr ermöglicht, sich auf dem Substrat (12) auszubreiten, und
- nach dem Bilden des Stapels (56) dem Element (12) ermöglicht wird, sich vertikal in zwei Richtungen, d. h. sowohl nach oben als auch nach unten, zu verlagern, und
**dadurch gekennzeichnet, dass** während des Erhitzens die Veränderung der vertikalen Position des Elements (12) gemessen wird.

2. Verfahren nach Anspruch 1, wobei das Erhitzen der Masse (16) als Funktion eines Parameters beendet wird, der von dem Maß der Veränderung der vertikalen Position des Elements (12) abhängt.

3. Verfahren nach Anspruch 1 oder 2, wobei im Verlauf des Erhitzens eine Stabilisierung der vertikalen Position des Elements (12) nach einem Absenken des Elements (12) detektiert wird und das Erhitzen der Masse (16) nach einer vorgegebenen Dauer, die ausgehend von der Detektion der Stabilisierung gezählt wird, beendet wird.

4. Verfahren nach einem der Ansprüche 1 bis 3, wobei zum Erhitzen der Masse (16) ein Laserstrahlenbündel auf eine erste Fläche des Substrats (14) gegenüber einer die Masse (16) tragenden zweiten Fläche dieses Substrats (14) zu dem Ort dieser Masse (16) gelenkt wird.

5. Vorrichtung (18) zum Montieren eines Elements (12) auf einem Substrat durch Aufbringen einer ein Lötmittel (16) bildenden Masse, mit Mitteln (22) zum Verlagern des Elements (12), die einen Träger (25) umfassen, der ein Organ (26) zum Ergreifen des Elements trägt, **dadurch gekennzeichnet, dass** das Greiforgan (26) an dem Träger (25) translatorisch parallel zu einer so genannten vertikalen Translationsachse beweglich montiert ist und dass sie in der Weise konfiguriert ist, dass sich das Element in den zwei Richtungen, d. h. sowohl nach oben als auch nach unten, vertikal verlagern kann, und dass sie Mittel (44) zum Messen der Veränderung der vertikalen Translation der Position des Elements (12) umfasst.

6. Vorrichtung (18) nach dem vorhergehenden Anspruch, die Mittel (36) zum Erhitzen und Mittel (52) zum Steuern der Heizmittel (36) als Funktion der Veränderung der Position des Elements umfasst.

7. Vorrichtung nach Anspruch 5 oder 6, die Mittel (30, 30A, 30B) zum Begrenzen der vertikalen translatorischen Bahn des Elements (12) umfasst.

8. Vorrichtung (18) nach einem der Ansprüche 5 bis 7, die Mittel umfasst, die Gegengewichte bilden, die dem Gewicht des Greiforgans (26) wenigstens teilweise entgegenwirken.

9. Vorrichtung (18) nach einem der Ansprüche 5 bis 8, wobei die Mittel (44) zum Messen der Veränderung der Position des Elements (12) Mittel zum Messen der vertikalen translatorischen Veränderung der Position des Greiforgans (26) sind.

10. Vorrichtung (18) nach dem vorhergehenden Anspruch, wobei die Messmittel (44) Mittel (46) zum Aussenden eines auftreffenden Lichtstrahlenbündels umfassen, die dazu bestimmt sind, ein Strahlenbündel (48) auf eine Oberfläche (26S) des Greiforgans (26) im Wesentlichen senkrecht zu der vertikalen Achse auszusenden, und Mittel (50) zum Empfangen eines Teils des von dieser Oberfläche (26S) reflektierten Strahlenbündels (48) umfassen.

11. Vorrichtung (18) nach einem der Ansprüche 5 bis 10, wobei die Messmittel (44) einen Verlagerungssensor mit Lasertriangulation umfassen.
